# EUROPEAN PATENT APPLICATION

(11) **EP 3 382 406 A1**
(43) Date of publication of application: **03.10.2018**
(21) Application number: 17020126.3
(22) Date of filing: 30.03.2017
(51) Int. Cl.: G01R 19/02, G01R 19/175, G01R 19/25, G01R 19/257, G01R 21/00, G01R 21/06

(54) **A SYSTEM AND A METHOD FOR ESTIMATION OF CURRENT TRANSPORTED IN A CABLE**

(71) Applicant: NorthQ ApS, 2100 Kobenhavn Ø (DK)
(72) Inventor: Iacoboae, Dan, 2880 Bagsværd (DK)

(57) **Abstract**

A system (100) for estimation of current in a cable (102), the system comprising a current clamp (104), wherein the current clamp (104) is configured to generate a voltage proportional to the current being supplied in the cable (102), a rectifier (106) connected with the current clamp (104) and configured to rectify the voltage to generate a rectified voltage, an Analog to Digital Converter (ADC) (108) connected with the rectifier (106), wherein the ADC (108) is configured to convert the rectified voltage into a digital output and a control module (110) configured to receive the digital output and provide an estimate of the current.

## Description

### TECHNICAL FIELD

Embodiments of the present invention relate to current estimation and more particularly, to a system and a method for estimation of current in a cable that provides a high precision of the estimation without using any active element, such as an amplifier.

### BACKGROUND ART

Clamp-ons or clamps for power cables are clamps that may be fixed to or provided around a power cable and has a magnetic or electrical circuit configured to sense the current carried by the power cable without galvanic connection to the cable. Usually, clamp-ons are removable from the cable.

Usual clamp-ons have a two-part core with one or more coils around the two-part core. In some clamp-ons, one coil may be replaced by a wire simply extending around the core. Such clamp-ons are also called current transformers. As would also be appreciated by a person skilled in the art, it is desired to not only be able to detect as high a current as possible but also to have a good precision at low currents. A large number of windings are required to handle a large current, but this gives a low output for low currents.

Further, when digitization is used, an Analogue/Digital converter is used. Such converters have a limited range in that they will convert a maximum input voltage to a predetermined number of bits. Also, within that range, the resolution of the output is determined by the number of bits. Thus, it is desired to ensure that the input into the ADC is optimum under all circumstances in order to optimize the performance (resolution) thereof. As would also be appreciated by a person skilled in the art, it is possible to sample the signal with a higher granularity (go from 8 to 12 bits) but this is expensive.

Thus, in order to always have an optimum resolution in digital equipment, an amplifier is usually provided between the clamp-on and the ADC to ensure that the signal provided to the ADC takes advantage of the range of the ADC. Thus, if the signal from the clamp-on is low, the amplifier will amplify the signal so that the output of the ADC is suitable. Otherwise, the output of the ADC might be only low values, whereby (as only a few bits are then used), the resolution of these low values will be low. This, however, requires a feedback from the amplifier so that the amplification may be taken into account when converting the ADC output to a current value. Also, that amplifier will consume power.

Technology of this type may be seen in CN100403037C, RU17564U1, and US5057769A.

### SUMMARY OF THE INVENTION

A first aspect of the present invention relates to a system for measurement of current in a cable, the system comprising a current clamp, configured to generate a voltage proportional to the current, a rectifier connected with the current clamp and being configured to rectify the voltage to generate a rectified voltage, an Analog to Digital Converter (ADC) connected with the rectifier and being configured to convert the rectified voltage into a digital output and a control module configured to receive the digital output and provide an estimate of the current.

Using the present current clamp, the current value can be estimated without a galvanic connection between the cable and the system. This is particularly suitable for fast and easy measurement of current, such as, during preventive maintenance and diagnostics, in an environment where the electrical fittings are provided.

In this context, a cable is usually an elongate element having one or more conductors therein carrying the current. One set of conductors together may be carrying current of a single phase and the cable may be having a multitude of such sets for carrying current of multiple phases. If multiple phases are present, a clamp-on may be desired for each phase.

A current clamp or a clamp-on or simply clamp is an element configured to be positioned or provided around the cable/conductor. Preferably the current clamp comprises two jaws (biased towards a closed position) between which the cable may be provided, such as fixed. The current clamp may be operated to open the jaws so as to provide the clamp around the cable, and re-closed in order to completely encircle the cable. Preferably, the current clamp has a material which is sensitive to a magnetic field induced by the current transported in the cable. Then, a magnetic field may travel around the conductor in the current clamp. This magnetic field may be sensed and a voltage corresponding to the current may be output. The current clamp may comprise one or more conductors provided around the material to convert the magnetic field into the voltage. For example, the current clamp may have one or more windings around a ferromagnetic core to convert the magnetic field therein into a current and/or voltage carried by the windings.

The voltage is proportional to the current so that the estimated current may be derived from the voltage, such as on the basis of parameters of the current clamp, such as the material, the conductor/windings or the like. An algorithm may be defined from which the other variable may be determined from the first variable. For example, in the above situation with e.g. a ferromagnetic core and the one or more windings surrounding the ferromagnetic core, the voltage will depend on factors such as a number of windings and impedance of the windings; the algorithm may include such factors.

In the present context, waveforms may be unidirectional when they have values on one side of zero, usually with zero included. In other words, while a magnitude of the rectified voltage may change periodically or otherwise or be zero intermittently, for non-zero magnitudes, the rectified voltage either always remains positive or always remains negative.

In general, two elements or components may be connected with each other, even if this connection comprises another element, such as resistors, capacitors, inductors, diodes or the like, in between the element and the other element. In that situation, however, it is preferred that the intermediate elements/components are passive elements, meaning that they do not have a separate power supply.

In the present context, a digital output is a digital signal, such as a signal having one of two values ("0" and "1"). Usually, digital signals have a predetermined number of bits (for example an 8 bit value for an 8 bit ADC). The digital or binary output represents a value reflecting a value of the rectified voltage sampled by the ADC. Often, ADCs compare the signal input to a reference voltage, such as a supply voltage for the ADC and output a digital value representing a relation between the input voltage and the reference voltage. Often, if the input voltage is identical to the reference voltage, the digital output is maximum, which is the predetermined number of bits all being 1. If the input voltage is zero, the digital output is usually zero.

The control module may be a monolithic element, such as a chip, ASIC, FPGA, controller, processor DSP or the like. Alternatively, the control module may be multiple such elements communicating with each other. The control module may, as will be described further below, also have other tasks, other inputs, other outputs and may be configured to receive instructions from a user or a remote server and may be configured to output the derived information, such as the current, to a user, a display and/ or a remote entity.

The rectifier may in principle be any component or circuit configured to provided a unidirectional signal. Typical rectifiers may be selected from a group consisting of half-wave rectifiers, full-wave rectifiers. The half-wave rectifiers are simple, whereas, full wave rectifiers allow higher frequency estimation of the current, thereby allowing sensing of rapid changes in current consumption. Halfwave/fullwave rectifiers may be provided using only diodes. Passive (not power supplied) components are preferred.

The control module may further be configured to determine a reference or supply voltage supplied to the ADC. This voltage may be used in the estimation of the current. The digital output of the ADC may depend on the reference/supply voltage supplied to the ADC. Hence, determination of the reference voltage is may be used for obtaining a more accurate estimation of the current.

The control module may further be configured to instruct the ADC to sample the rectified voltage for a predetermined period of time. The sampling can be performed for specific periods of time and the ADC can be put to sleep between these periods of time to save power.

The period of time may be selected on the basis of a period of the voltage supplied in the cable or the voltage output of the current clamp. The predetermined period of time may be an integer multiple of one time period of the current/voltage. Sampling during an integer multiple of one time period ensures that one complete waveform is sampled irrespective of when, during a period, the sampling begins. Current consumption may vary over time, but a determination thereof e.g. once each second or one period out of 50, such as one in 20 periods, one in 10 periods or one in 5 periods of the (usually sine-shaped) current/voltage may be sufficient. Also, half a period or another predetermined proportion of a period may be used (as the two halves of the sine shape are identical). For example if the voltage/current variation has a frequency 50 Hz, one time period would be 20 milliseconds. Alternatively, if the frequency is 60 Hz, one time period would be 16.67 milliseconds. Especially when using the below-described zero crossing determination of the current or voltage output of the current clamp, the period or a portion thereof may easily be determined.

The control module may further be configured to put the ADC to sleep between two predetermined waveforms of the rectified voltage. Putting the ADC to sleep allows power to be saved when no waveform is present or when no change in current consumption is expected. This makes the system suitable for battery operation. In the present context, "putting to sleep" may be to instruct the ADC to not convert any input signal into a digital output. Often, electrical circuits have different sleep modes. The ADC may sleep for a predetermined period of time or be able to be woken up if required.

Naturally, the ADC may also or additionally have a varying conversion frequency. A lower power consumption may be obtained by reducing the conversion frequency. Thus, a low conversion frequency may be used when a constant current consumption is or expected.

Preferably, the current clamp and the ADC do not include a power consuming element there between. In other words, a signal path between the current clamp output and the ADC input comprises, if it is not merely a conductor, only passive (not power-supplied) components. As would also be appreciated by a person skilled in the art, components may consume power (a resistor gets hot), but no separate power is supplied to such components. The absence of such active elements, such as amplifiers, ensures even lesser power consumption, making the system even more suitable for battery operation.

The present system is suited for being powered by a battery. Powering the system by battery allows the system to be portable and easy to carry between different locations.

In a preferred embodiment, the system further comprises a first zero crossing detector configured to detect first zero crossings of the voltage. The first zero crossings allow accurate detection of beginnings and endings of the waveforms of the rectified voltage. In usual set-ups with AC power supplied through the cable, the output of the clamp will be a sine-shaped voltage varying around zero. Zero detection may be performed in a number of manners.

In that or another embodiment, the system further comprises a voltage sensor configured to sense a supply voltage being supplied by the cable and generate a second digital output proportional to the supply voltage. Further, the control module may be configured to estimate the supply voltage from the second digital output. Knowing the voltage and current supplied, a power value of power supplied by the cable may be determined, as a function of the estimated current, the estimated voltage and a phase between these two values. This phase may be determined from the first zero crossings and second zero crossings determined of the supply voltage. Different phase differences will be representative of different amounts of power carried by the cable for the same voltage and current.

Naturally, the voltage sensor may be based on any technology. Voltage sensors may or may not be in galvanic connection with the cable or a conductor thereof.

A sensor not being in galvanic connection may be based on magnetic induction. The voltage sensor may include one or more components performing different functions such as generating a signal in response to the supply voltage, processing the signal and converting the signal to a "second digital output". The second digital output may also be a digital value of a certain number of bits. In general, the voltage sensor may have another ADC, and the above description, including that of using the voltage supplied to that ADC in the determination of the voltage, apply equally here.

Then, the system preferably further comprises a second zero crossing detector configured to detect the second zero crossings. The first zero crossings and second zero crossings together allow determination of a phase difference between the current and the supply voltage.

A second aspect of the present invention relates to a method for estimation of current transported in a cable, the method comprising the steps of generating a voltage proportional to the current being supplied in the cable, rectifying the voltage to generate a rectified voltage, converting the rectified voltage into a digital output and receiving the digital output and providing an estimate of a current value of the current.

As mentioned above, the step of rectifying may comprise the step of performing rectification by using half-wave rectifiers or full-wave rectifiers.

Preferably, the method further comprises the step of determining a reference voltage being supplied to the ADC, wherein the estimating step comprises estimating the voltage also on the basis of the determined supply voltage.

The method may comprise the step of instructing the ADC to sample the rectified voltage for a predetermined period of time. This predetermined period of time may be an integer multiple of one time period of the current.

The method may further comprise the step of putting the ADC to sleep between two predetermined waveforms of the rectified voltage.

As would also be appreciated by a person skilled in the art, in addition or alternatively, the estimation may also be performed only intermittently, so as to only perform this determination, and thus use power, for a portion of e.g. a period of the voltage or for a portion thereof.

Preferably, the method further comprises the step of determining first zero crossings of the voltage output by the current clamp. Then, the estimating step may use the zero crossings to e.g. determine periods of time in which the sample the rectified voltage.

Preferably, the method further comprises the steps of sensing a supply voltage being supplied in the cable and generating a second digital output proportional to the supply voltage. Then, the supplied voltage may be, estimated from the second digital output. Then, second zero crossings of the supply voltage (or second digital output or an intermediate signal) may be determined. Then, an estimate of the power supplied by the cable may be made from the estimated current, the estimated voltage, the first zero crossings and the second zero crossings.

### BRIEF DESCRIPTION OF THE ACCOMPANYING DRAWINGS

In the following, preferred embodiments of the invention will be described with reference to the drawing, wherein:
Fig. 1 illustrates a system for estimation of current transported in a cable,
Fig. 2 illustrates a Voltage - Time plot of a voltage output of the clamp,
Fig. 3 illustrates a method for estimation of current transported in a cable,
Fig. 4 illustrates a Voltage - Time plot of a half-wave rectified voltage,
Fig. 5 illustrates a Voltage - Time plot of a full-wave rectified voltage, and
Fig. 6 illustrates another Voltage - Time plot of a rectified voltage.

### DETAILED DESCRIPTION OF THE PREFERRED EMBODIMENTS

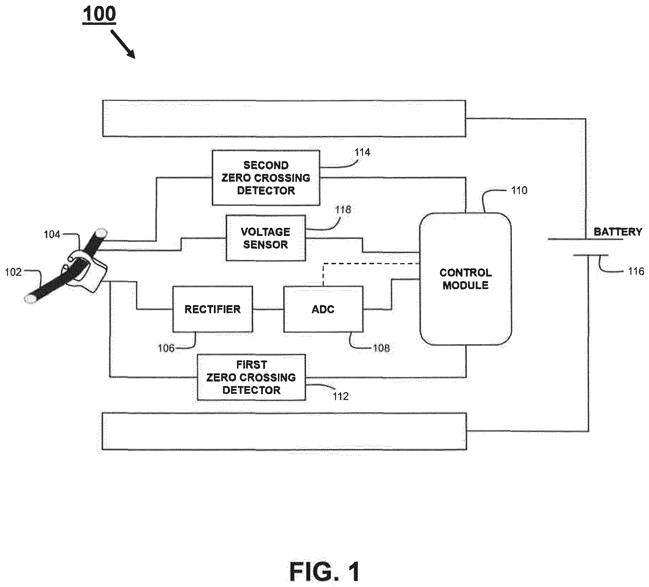

Figure 1 illustrates a system 100 for estimation of current in a cable 102. The system comprises a current clamp 104, a rectifier 106 connected with the current clamp 104, an Analog to Digital Converter (ADC) 108 connected with the rectifier 106 and a control module 110. The current clamp 104 has a cavity between two jaws, through which the cable 102 passes. The system 100 is powered by a battery 116 so as to be portable and easy to carry between different locations.

In accordance with various embodiments, the current clamp 104 is one of, but not limited to, current transformer type having winding around a ferrite or a soft iron core, Hall effect type and Rogowski coil type. The Rogowski coil type is a coreless transformer.

The current clamp 104 is configured to generate a voltage proportional to the current being supplied in the cable 102. In any of the types of the current clamp 104, the voltage is generated in response to a magnetic flux generated by the current being supplied in cable 102. Hence no galvanic connection is required when using the current clamp 104. This is particularly suitable for fast and easy measurement of current, such as, during preventive maintenance and diagnostics, in an environment where the electrical fittings are provided, or when used by non-experts.

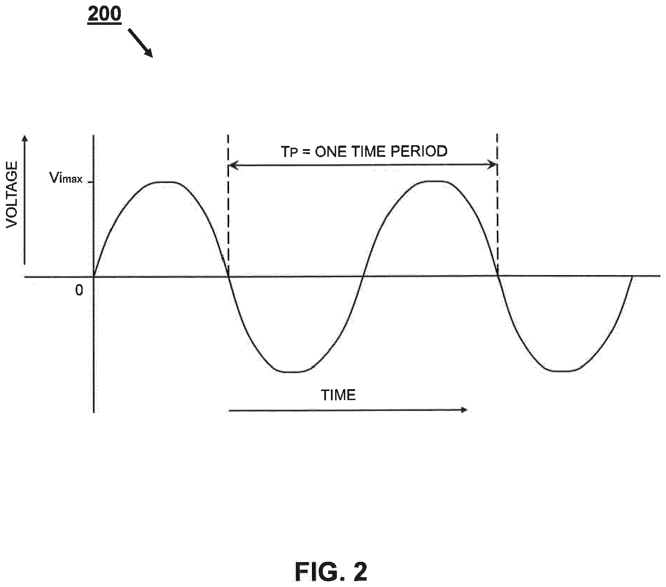

Figure 2 illustrates a Voltage - Time plot 200 of the voltage output of the clamp. As shown in figure 2, the voltage has an amplitude Viₘₐₓ and a time period T_{P}. For example, if a frequency of the current is 50 Hz, the frequency of voltage will also be 50Hz and the time period T_{P} of the voltage and the current would be 20 ms.

As would also be appreciated by a person skilled in the art, any type of rectifier may be used. Halfwave/fullwave rectifiers may be provided using only diodes and thus passive (not power consuming) components which is preferred. Half-wave rectification allows saving of power during sampling by the ADC 108. Alternatively, full wave rectification allows higher-frequency estimate of the current value, so as to quickly identify changes in current being supplied in the cable 102. The rectifier 106 is configured to rectify the voltage to generate a rectified voltage: a voltage comprising only unidirectional waveforms: either only positive waveforms or only negative waveforms or voltages (including zero).

The ADC 108 is configured to sample and convert the rectified voltage into a digital output. The ADC 108 may a 12 bit ADC, but naturally, any number of bits may be used. Preferably, there is no active (power consuming) elements or components, such as amplifiers, between the current clamp 104 and the ADC 108. The absence of the active elements allows the system 100 to be operated at fairly minimal power consumption. As would also be appreciated by a person skilled in the art, components may consume power (a resistor gets hot), but it is still passive as no separate power is supplied to such components.

The control module 110 is configured to receive the digital output and provide an estimate of a current value of the current. The control module 110 may be configured to estimate the current value as a Root Mean Square (RMS) value of the digital output.

The control module 110 may further be configured to determine a supply voltage for the ADC 108, in order better to estimate the current value. The digital output of the ADC is a comparison between the input voltage and the supply voltage for the ADC. Thus, for example, if the supply voltage is 3V, a 3V input from the clamp gives a maximum ADC 108 output. If the ADC 108 supply voltage is 5V, the same 3V input gives only a 60% of the maximum ADC 108 output (3/5=60%).

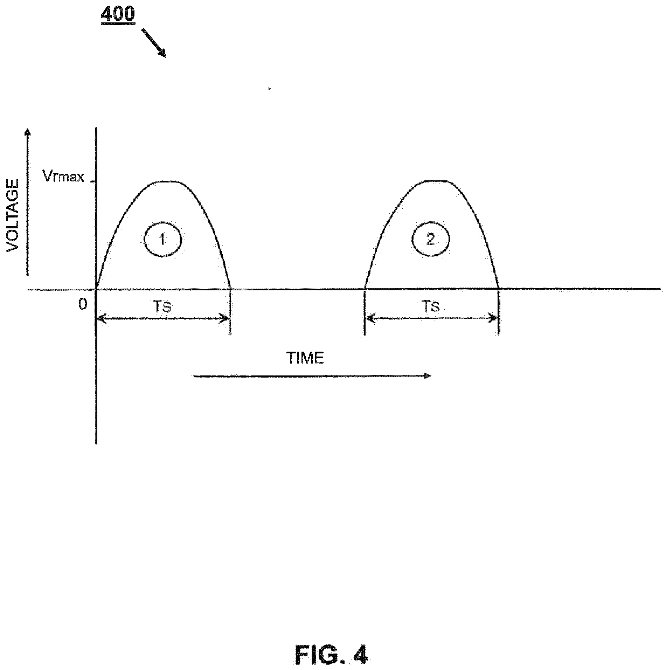

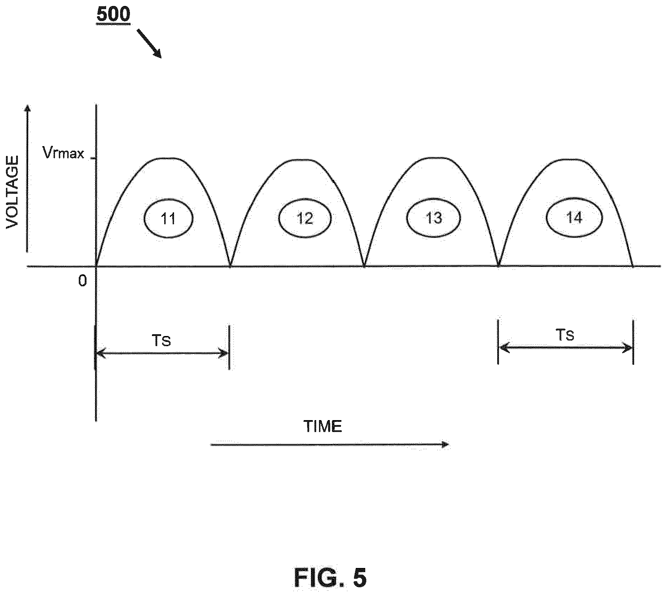

The sampling can be performed for specific periods of time and the ADC 108 can be put to sleep intermittently thus allowing power to be saved. The control module 110 may further be configured to put the ADC 108 to sleep between two predetermined waveforms of the rectified voltage. For example, in case where the rectified voltage is a half-wave rectified voltage (figure 4), the control module 110 may be configured to put the ADC 108 to sleep between two consecutive waveforms. In another example, irrespective of the rectified voltage being the half-wave rectified voltage or a full-wave rectified voltage (figure 5), the control module 110 may be configured to put ADC 108 to sleep between any two predetermined non-consecutive waveforms, when no change in consumption of the current is foreseen. This means that the ADC 108 may be put to sleep for any number of waveforms, depending upon the foreseeable consumption of current. In this context, "putting to sleep" may be to instruct the ADC 108 to not convert any input signal. As would also be appreciated by a person skilled in the art, the ADC 108 may also have a differing conversion frequency when e.g. a constant current consumption is seen, whereby the current waveform may be determined with a lower frequency, again saving power.

The system 100 further comprises a first zero crossing detector 112 configured to detect first zero crossings of the voltage from the clamp. The first zero crossings are detected from time to time and may be used to ensure that the predetermined waveforms are sampled completely by the ADC 108. The respective starts of the predetermined waveforms are detected so that the sampling may start when or before a next predetermined waveform is expected. In usual set-ups with AC power supplied through the cable 102, the output of the current clamp 104 will be a sine-shaped voltage varying around zero. Zero detection may be performed in a number of manners.

The control module 110 is configured to instruct the ADC 108 to sample the rectified voltage for a predetermined period of time. Sampling for the predetermined period of time allows the control module 110 to put the ADC 108 to sleep intermittently. The predetermined period of time is the one time period T_{P}, of the current. Sampling the rectified voltage for integer multiple of one time period ensures that one complete waveform is sampled irrespective of where the sampling starts.

The system 100 further comprises a voltage sensor 118 configured to sense a supply voltage being supplied in the cable 102 and generate a second digital output proportional to the supply voltage. This voltage sensor 118 preferably is in galvanic connection with the cable 102 in order to sense the supply voltage. Alternatively, the voltage sensor 118 further comprises one or more operating amplifiers configured to convert the supply voltage into a lower voltage. Also another ADC may be provided for generating the second digital output, which may be fed to the control module 110. Further, the control module 110 is configured to estimate a voltage value of the supply voltage, from the second digital output and determine a power value of power being supplied by the cable 102.

The power value may be determined as a function of the current value, the voltage value, the first zero crossings and second zero crossings of the supply voltage, the lower voltage or the second digital output. The control module 110 is configured to determine a phase difference between the current and the supply voltage in cable 102, from the first zero crossings and the second zero crossings. The system 100 may then further comprise a second zero crossing detector 114 configured to detect the second zero crossings.

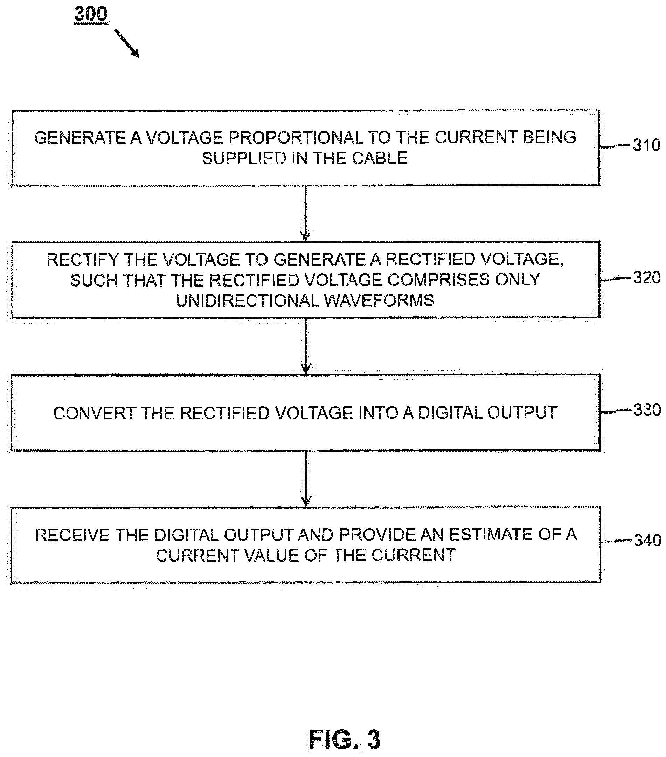

Figure 3 illustrates a method 300 for estimation of the current in the cable 102. The method begins at step 310 by the clamp generating the voltage proportional to the current supplied in the cable 102. At step 320, the voltage is rectified by the rectifier 106 to generate the rectified voltage.

At step 330, the rectified voltage is converted into the digital output by the ADC 108, this step involves sampling of the rectified voltage by the ADC 108. The sampling is regulated by the control module 110 as discussed below.

As mentioned, the control module 110 may put the ADC 108 to sleep between two predetermined waveforms of the rectified voltage. Figure 4 illustrates a Voltage - Time plot of a half-wave rectified voltage. T_{S} denotes sampling time and Vrₘₐₓ denotes an amplitude of the rectified voltage. In this embodiment 400, the sampling is performed by the ADC 108 for two consecutive waveforms 1 and 2 of the half-wave rectified voltage. And the ADC 108 is put to sleep, by the control module 110, between the waveforms 1 and 2, as there is no waveform between waveforms 1 and 2.

Figure 5 illustrates a Voltage - Time plot of a full-wave rectified voltage. In this embodiment 500, the sampling may be performed only for e.g. waveforms 11 and 14 of the rectified voltage. The ADC 108 may be put to sleep during waveforms 12 and 13, if no change in current consumption is expected during the waveforms 12 and 13.

The first zero crossings of the voltage may be detected by the first zero crossing detector 112. As discussed above, the first zero crossings may be detected for each crossing or only from time to time, so as to ensure that the predetermined waveforms are sampled completely by the ADC 108. The respective starts of the predetermined waveforms are detected so that the sampling may start when or before a next predetermined waveform is expected.

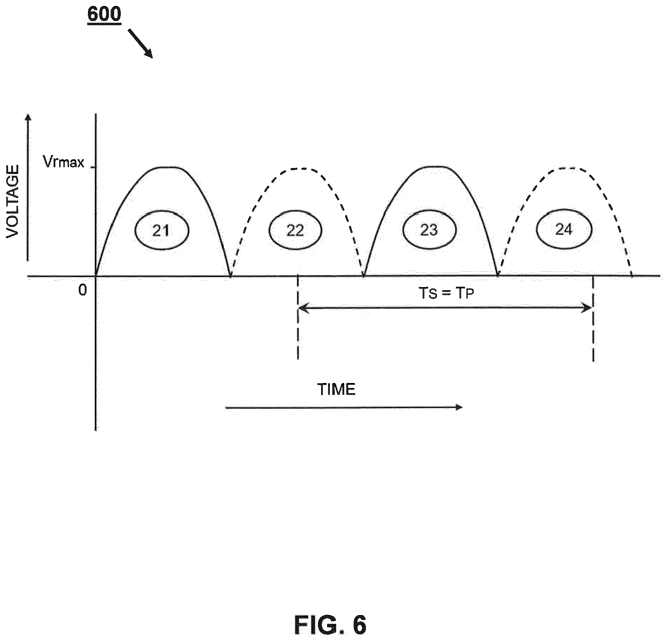

The control module 110 may instruct the ADC 108 to sample the rectified voltage during a full period of the current. Figure 6 illustrates another Voltage - Time plot of the rectified voltage. The waveforms 21 and 23 are the originally positive waveforms and the waveforms 22 and 24 are the originally negative waveforms. Only one of the negative and positive waveforms is required, but the period of the signal still is defined by a negative and a positive waveform. This is illustrated in figure 6. Thus, sampling the waveform, irrespectively of the rectification type used, for this period of time ensures that one entire waveform 23 is sampled, irrespective of where the sampling starts and whether the rectified voltage is half-wave rectified or full wave rectified.

At step 340, the digital output is received by the control module 110 and the estimate of the current value of the current is provided by the control module 110. As mentioned, the supply voltage supplied to the ADC 108 may be taken into account by the control module 110 when estimating the current.value. The voltage senor 118 may be provided for sensing the supply voltage supplied in the cable 102 and for generating the second digital output proportional to the supply voltage. Further, the control module 110 may then estimate a voltage value of the supply voltage, from the second digital output. Further, the second zero crossing detector 114 may detect the second zero crossings of the supply voltage. The control module 110 then may determine the power value of the power being supplied by the cable 102, as a function of the current value, the voltage value, the first zero crossings and the second zero crossings.

The method and the system for estimation of current in a cable are simple and efficient. Further, the ADC can be put to sleep from time to time ensuring even lower power consumption. Further, the invention does not involve any active elements, such as amplifiers, anywhere between the current clamp and the ADC. Therefore the present invention is suitable for battery operation and can be encapsulated in portable housings and used at multiple locations with relative ease.

Various modifications to these embodiments are apparent to those skilled in the art from the description and the accompanying drawings. The principles associated with the various embodiments described herein may be applied to other embodiments. Therefore, the description is not intended to be limited to the embodiments shown along with the accompanying drawings but is to be providing broadest scope of consistent with the principles and the novel and inventive features disclosed or suggested herein. Accordingly, the invention is anticipated to hold on to all other such alternatives, modifications, and variations that fall within the scope of the present invention and appended claim.

## Claims

1. A system (100) for estimation of current transported in a cable (102), the system (100) comprising:
a current clamp (104) configured to generate a voltage proportional to the current;
a rectifier (106) connected to the current clamp (104), wherein the rectifier (106) is configured to rectify the voltage to generate a rectified voltage,
an Analog to Digital Converter (ADC) (108) connected to the rectifier (106) and being configured to convert the rectified voltage into a digital output; and
a control module (110) configured to receive the digital output and provide an estimate of the current.

2. The system (100) as claimed in claim 1, wherein the rectifier (106) is selected from a group consisting of half-wave rectifiers, full-wave rectifiers.

3. The system (100) as claimed in claim 1 or 2, wherein the control module (110) is further configured to determine a supply voltage being supplied to the ADC (108) and base the estimate of the current also on the supply voltage determined.

4. The system (100) as claimed in any of claims 1-3, wherein the control module (110) is further configured to instruct the ADC (108) to sample the rectified voltage for a predetermined period of time.

5. The system (100) as claimed in claim 4, wherein the predetermined period of time is an integer multiple of one time period of the current.

6. The system (100) as claimed in any of claims 1-5, wherein the control module (110) is further configured to put the ADC (108) to sleep between two predetermined waveforms of the rectified voltage.

7. The system (100) as claimed in any of claims 1-6, wherein the current clamp (104) and the ADC (108) do not include a power consuming element there between.

8. The system (100) as claimed in any of claims 1-7, wherein the system (100) is being powered by a battery (116).

9. The system (100) as claimed in any of claims 1-8, further comprising a first zero crossing detector (112) configured to detect first zero crossings of the voltage.

10. The system (100) as claimed in claim 9, further comprising a voltage sensor (118) configured to sense a supply voltage being supplied in the cable (102) and generate a second digital output proportional to the supply voltage; wherein the control module (110) is further configured to:
estimate a voltage value of the supply voltage from the second digital output; and
estimate the power supplied by the cable (102), as a function of the estimated current, the estimated voltage, the first zero crossings and second zero crossings of the supply voltage.

11. The system (100) as claimed in claim 10, further comprising a second zero crossing detector (114) configured to detect the second zero crossings.

12. A method (300) for estimating a current transported in a cable, the method (300) comprising the steps of:
generating (310) a voltage proportional to the current;
rectifying (320) the voltage to generate a rectified voltage,
converting (330) the rectified voltage into a digital output; and
estimating the current on the basis of the digital output.

13. The method (300) as claimed in claim 12, further comprising the step of determining a supply voltage being supplied to the ADC (108), wherein the estimating step comprises estimating the voltage also on the basis of the determined supply voltage.

14. The method (300) as claimed in claim 12 or 13, further comprising the step of determining first zero crossings of the voltage.

15. The method (300) as claimed in claim 14, further comprising the steps of:
sensing a supply voltage being supplied in the cable (102) and generating a second digital output proportional to the sensed supply voltage;
estimating a voltage value of the supply voltage, from the second digital output;
detecting second zero crossings of the supply voltage; and
estimating the power supplied by the cable as a function of the current, the voltage value, the first zero crossings and the second zero crossings.
